# EUROPEAN PATENT APPLICATION

(11) **EP 1 924 002 A1**
(43) Date of publication of application: **21.05.2008**
(21) Application number: 07120161.0
(22) Date of filing: 07.11.2007
(51) Int. Cl.: H04B 1/08, H04B 1/16, H03J 1/00

(54) **Radio receiver and method of dynamically setting tuning parameters based on location**

(30) Priority: 16.11.2006 US 600546
(71) Applicant: Delphi Technologies, Inc., Troy, Michigan 48007 (US)
(72) Inventor: Ray, William Martin, Sharpsville, IN 46068 (US)
(74) Representative: Denton, Michael John

(57) **Abstract**

A method (100) of dynamically setting tuning parameters and a radio receiver (12) are provided. The method (100) includes the step of storing one or more tuning parameters (24) for each of a plurality of geographic locations. The method also includes the steps of determining a current geographic location of the radio receiver (12), and the step of selecting one or more tuning parameters (24) for the determined geographic location. The method further includes the step of dynamically adjusting the tuner (30) based on the select one or more tuning parameters (24).

## Description

### Technical Field

The present invention generally relates to radio receivers and, more particularly relates to setting tuning parameters in the tuner of a radio receiver.

### Background of the Invention

Automotive vehicles are commonly equipped with radios for receiving wireless broadcast radio frequency (RF) signals. The radio processes the received RF signals and broadcasts audio sound and other information to passengers in the vehicle, as the vehicle is able to travel amongst various locations. The radio typically includes various electronics including an RF tuner. The RF tuner selects a frequency bandwidth of input RF signals and outputs audio signals that are typically amplified and broadcast via audio speakers. The tuner may include frequency modulated (FM) tuning for receiving FM modulated signals and amplitude modulated (AM) tuning for receiving AM signals.

Conventional vehicle radio receivers are typically programmed with preset tuning parameters that determine the tuner settings. Tuning parameters typically include parameters that adjust the application of automatic gain control (AGC), parameters that adjust the intermediate frequency (IF) bandwidth, parameters that adjust audio channel separation, parameters that adjust audio high frequency roll-off, and parameters that adjust audio amplitude. The preset tuning parameters typically do not change and are initially selected in an attempt to accommodate a wide range of signal reception conditions.

In conventional receivers, the preset tuning parameters attempt to accommodate variations in signal strength that may be experienced when the radio receivers operate in geographic different locations. For example, when a vehicle equipped with a radio receiver travels within an urban setting, the radio receiver may receive several strong signals from relatively close radio broadcast stations, whereas when traveling in a rural setting, the radio receiver may receive several relatively weak signals broadcast from relatively distant radio broadcast stations. In some situations, it may be desirable to prevent strong signal overload that may prevent clear reception of other broadcast stations. In other situations, it may be desirable to allow for receipt of weak distant broadcast stations. To realize sufficient tuner performance in these special conditions, the tuning parameters may have to be appropriately selected to accommodate for such conditions.

It is therefore desirable to provide for a radio receiver having a tuner that allows for enhanced signal reception and tuning of radio wave signals in a variety of reception conditions. Specifically, it would be desirable to provide for a tuner that may be able to provide enhanced performance when experiencing strong signal overload, and reception of extremely weak distant broadcast stations in remote areas, such that the radio receiver tuner performs adequately in various conditions.

### Summary of the Invention

According to one aspect of the present invention, a method of dynamically setting tuning parameters for a radio receiver is provided. The method includes the step of storing one or more tuning parameters for each of a plurality of geographic locations. The method also includes the steps of determining a current geographic location of the radio receiver, and the step of selecting one or more tuning parameters for the determined geographic location. The method further includes the step of dynamically adjusting the tuner based on the selected one or more tuning parameters.

According to another aspect of the present invention, a radio receiver is provided having dynamically selectable tuning parameters. The radio receiver includes a first input for receiving radio frequency signals and a second input for receiving a determined geographic location of the radio receiver. The radio receiver also includes a tuner comprising tuner parameter settings, and memory storing tuning parameters for a plurality of geographic locations. The radio receiver further includes a controller selecting one or more tuning parameters for the determined geographic location and dynamically adjusting the tuner based on the selected one or more tuning parameters.

The method and radio receiver enables selection of tuning parameters based on the current geographic location which advantageously allows for optimal signal tuning in various reception conditions. Specifically, the method and system advantageously allow for enhanced tuner performance in conditions such as when experiencing strong signal overload or reception of extremely weak distant broadcast stations in remote areas. The method and system are particularly useful in a mobile radio receiver, such as a radio receiver employed on board a vehicle.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
FIG. 1 is a perspective view of a mobile vehicle equipped with a radio receiver and a global positioning system (GPS) receiver;
FIG. 2 is a block diagram of a radio receiver having dynamically adjustable tuning parameters based on geographic location, according to one embodiment of the present invention;
FIG. 3 is a block diagram of the radio tuner electronics that can be dynamically adjusted with the tuning parameters; and
FIG. 4 is a flow diagram illustrating a routine for dynamically selecting tuning parameters for the tuner based on geographic location according to one embodiment of the present invention.

### Description of the Preferred Embodiment

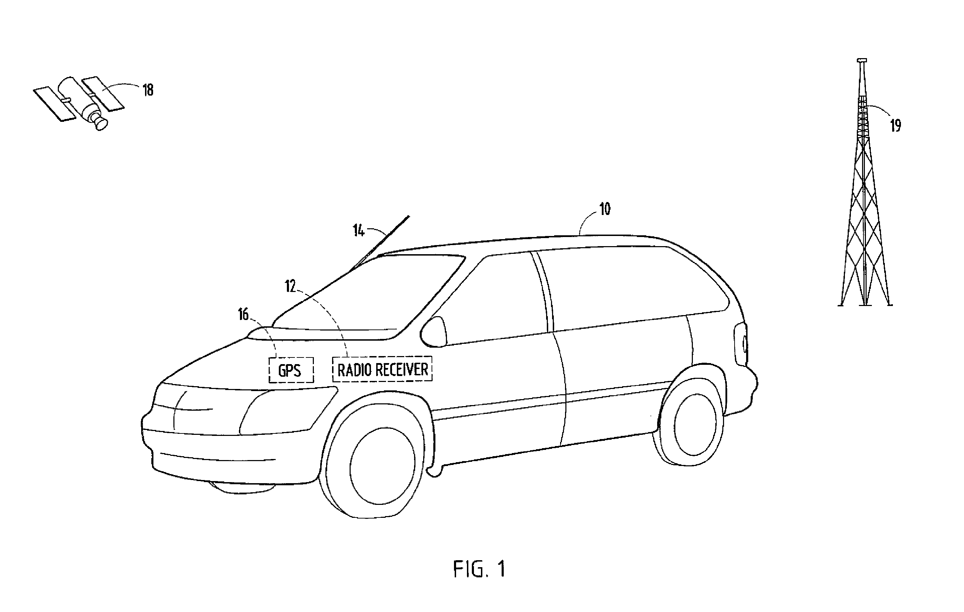

Referring now to FIG. 1, an automotive passenger vehicle 10 is generally illustrated equipped with a radio receiver 12, a radio antenna 14, and a global positioning system (GPS) receiver 16. The radio receiver 12 as described herein is dynamically reconfigurable so as to allow for adjustment of tuning parameters based on a geographic location determined from a location determining device, such as the GPS receiver 16. The radio receiver 12, antenna 14 and GPS receiver 16 may be located at various locations on board the vehicle or may be located elsewhere off the vehicle. The radio receiver 12 may receive radio frequency (RF) signals that are broadcast from either a terrestrial broadcast antenna 19 or a satellite 18, as should be evident to those skilled in the art. The RF signals are received at an input from antenna 14. Additionally, the GPS receiver 16 receives GPS signals broadcast from a satellite 19, as should be evident to those in the art. The GPS signals are received at another input of radio receiver 12.

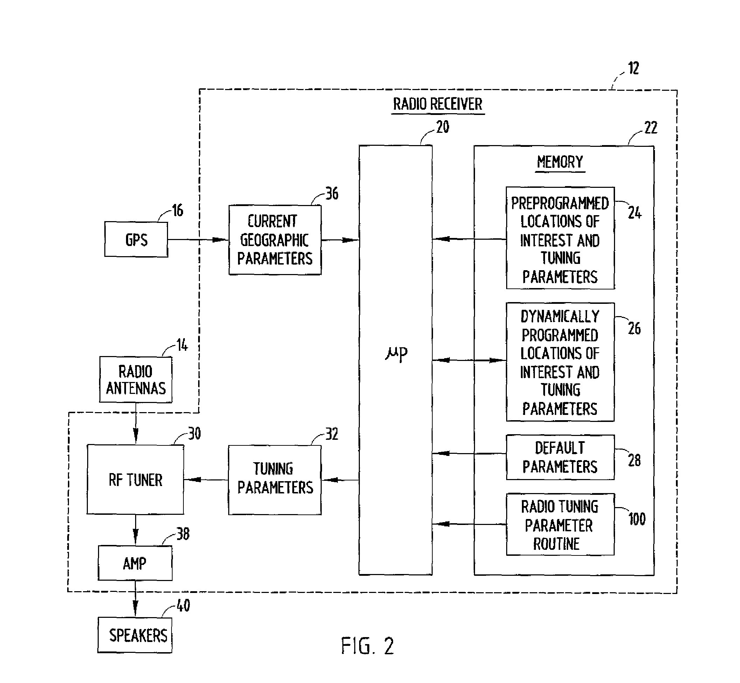

The radio receiver 12 is further illustrated in FIG. 2 having an RF tuner 30, a microprocessor 20 and memory 22. The tuner 30 receives RF signals input from one or more radio antennas 14 pass the input RF signals within a select tuned frequency bandwidth, and outputs audio signals. The tuner 30 may include frequency modulated (FM) tuning and/or amplitude modulated (AM) tuning, as should be evident to those in the art. The tuner 30 includes various electronics for processing the RF signals. The tuner 30 includes electronics that may be dynamically adjusted via tuning parameters as described herein to adjust the performance of the tuner 30 according to the present invention. The tuner 30 outputs the audio signals to an amplifier 38 which, in turn, outputs amplified audio signals to audio speakers 40.

The memory 22 may include random access memory (RAM), read-only memory (ROM), electrically erasable programmable read-only memory (EEPROM), and any other volatile or non-volatile memory storage medium. Stored within memory 22 are preprogrammed locations of interest and tuning parameters 24 that correspond to those locations. The preprogrammed locations of interest and tuning parameters 24 include tuning parameters that are preprogrammed into memory 22 for particular locations of interest. Also stored in memory 22 are dynamically programmable locations of interest and tuning parameters 26 that correspond to those locations. The dynamically programmed locations of interest and tuning parameters 26 may include tuning parameters that are dynamically programmed by a vehicle operator or other person after the radio receiver 12 is initially configured. This may include a driver of the vehicle or service technician inputting into memory 22 certain tuning parameters that are found to enhance the tuning performance for particular geographic locations. Further stored in memory 22 are default parameters 28 which may include default tuning parameters that may be used to set the tuning parameters of the tuner 30 in the event other programmed tuning parameters are not available or do not suffice. Finally, a radio tuning parameter routine 100 is also stored in memory 22 for dynamically setting tuning parameters for the tuner, according to one embodiment of the present invention.

The radio receiver 12 also includes an input for receiving current geographic parameters 36 from a location determining device, shown as a GPS receiver 16. The current geographic parameters 36 may include longitude and latitude position coordinates indicative of the geographic location determined by the GPS receiver 16. While the GPS receiver 16 is shown and described herein, it should be appreciated that other location determining devices may be employed, such as location information acquired from a navigation system, a radio data system (RDS) or other telematics devices that offer geographic location information.

The microprocessor 20 may include any known conventional processor or other control circuitry for executing the radio tuning parameter routine 100 and processing the various tuning parameters 24, 26 and 28 and the current geographic parameters 36 received from GPS receiver 16. The microprocessor 20 processes the routine 100 and the parameters, in addition to various tuner settings, and selects the tuning parameters 32 to configure the tuner 30 to achieve good tuner performance satisfactory in various conditions according to the present invention. It should be appreciated that the processor 20 may be dedicated to the radio receiver 12, or may include a shared processor that has other functions.

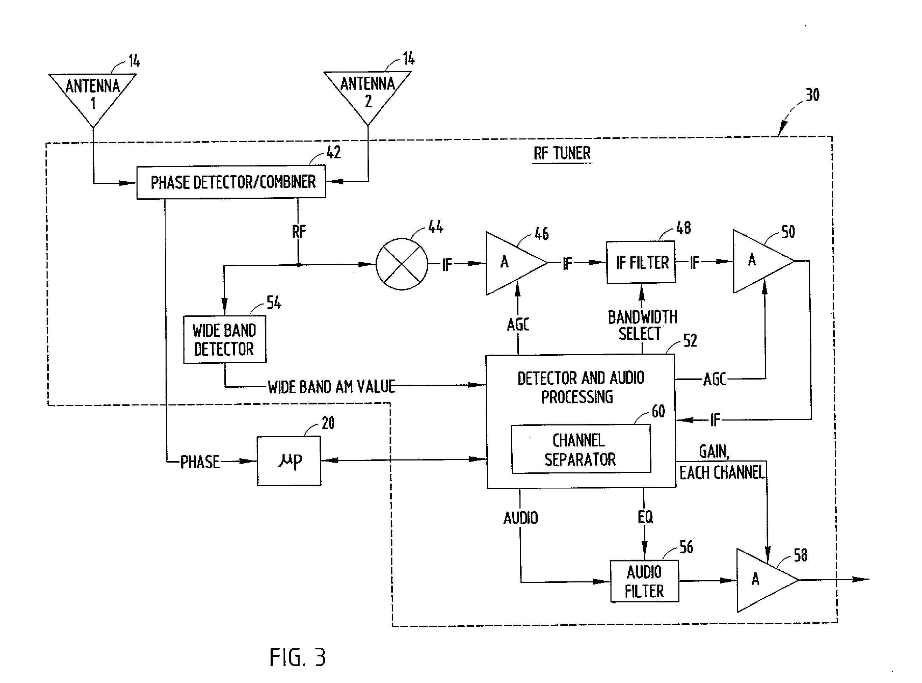

Referring to FIG. 3, the RF tuner 30 is further illustrated according to one embodiment having various electronics for selecting a frequency bandwidth of audio data to pass RF signals within a tuned frequency bandwidth and attempt to achieve optimal tuner performance under various conditions. The electronics of the tuner 30 includes a phase detector/combiner 42 for receiving RF signals from one or more antennas. In the embodiment shown, a pair of antennas 14, labeled antenna 1 and antenna 2, is illustrated according to a diversity antenna system. However, it should be appreciated that one or more antennas may be employed to receive RF signals. The phase detector/combiner 42 detects the phase and combines the signals according to this embodiment.

The tuner 30 also includes a mixer 44 for receiving the RF signals from combiner 42 and outputting intermediate frequency (IF) signals to an amplifier 46. Amplifier 46 amplifies the IF signals which, in turn, are input to an IF filter 48. A detector and audio processing block 52 provides an automatic gain control (AGC) signal to the amplifier 46, a bandwidth selection signal to the IF filter 48, and an AGC signal to amplifier 50. The filtered IF signal is then amplified by amplifier 50.

The output for amplifier 50 is input to the detector and audio processing block 52 as an IF signal. Additionally, the detector and audio processing block 52 receives a wide band AM value from the wide band detector 54 which, in turn, receives the RF signal output from combiner 42. The detector and audio processing block 52 communicates with the microprocessor 20 and performs various functions including providing an automatic gain control signals, bandwidth selection signals, equalization and audio signal outputs. Additionally, the processing block 52 includes a channel separation block 60.

The tuner 30 also includes an audio filter 56 for receiving audio signals and equalization signals from the detector and audio processing block 52. The output of audio filter 56 is provided as an input to an amplifier 58. Amplifier 58 also receives a gain signal for each channel from the detector and audio processing block 52. The output of amplifier 58 is then output from the tuner 30 to an amplifier to further amplify the signal before the audio sound is broadcast from one or more speakers.

The tuning parameters may include any of a number of parameters that adjust the performance of the tuner 30. One example of tuning parameters includes parameters that adjust the gain supplied to amplifier 50 as the automatic gain control (AGC) signal. Changes to the automatic gain control signal may adjust the threshold, decay time, and/or attack time for the tuner 30. Another example of the tuning parameters may include parameters that select the IF bandwidth selection signal that controls the IF filter 48. Adjustments to the IF bandwidth select signal may adjust the bandwidth so as to narrow or widen the IF bandwidth. Another example of tuning parameters include channel separation achieved by block 60 which affects how much of the left channel interferes with the right channel, and vice versa. The channel separation may control how much stereo versus mono is in the output audio signal. The channel separation is provided in the audio signal supplied to the audio filter 56, in the embodiment shown. Another example of tuning parameters may include parameters that adjust the high frequency roll-off which essentially adjusts the frequency response of the audio filter 56. Adjustment of the audio filter 56 by signal equalization (EQ) may be employed to reduce the high frequency (e.g., treble) audio. A further example of tuning parameters may include the parameters that affect the audio amplitude set by the gain signal for each channel signal supplied to the amplifier 58. The gain signal can adjust the gain of each channel to adjust the audio amplitude achieved with the tuner 30.

It should be appreciated that these and other tuning parameters may be dynamically adjusted based on the geographic location according to the present invention. It should further be appreciates that the tuner 30 may be alternatively configured to perform the tuning functions of a radio receiver. Tuner 30 may be implemented in analog or digital circuitry, or may be implemented in both analog and digital circuitry, as should be evident to those in the art. The tuning parameters may be implemented in digital and/or analog form, depending on the tuner configuration. Additionally, it should be appreciated that the processor 20 may monitor the state of the tuner signals and settings such as wide band amplitude modulation, ultrasonic noise, signal strength, relative phase between two antennas, adjacent channel interference and other parameters in determining current and future settings of the tuner parameters.

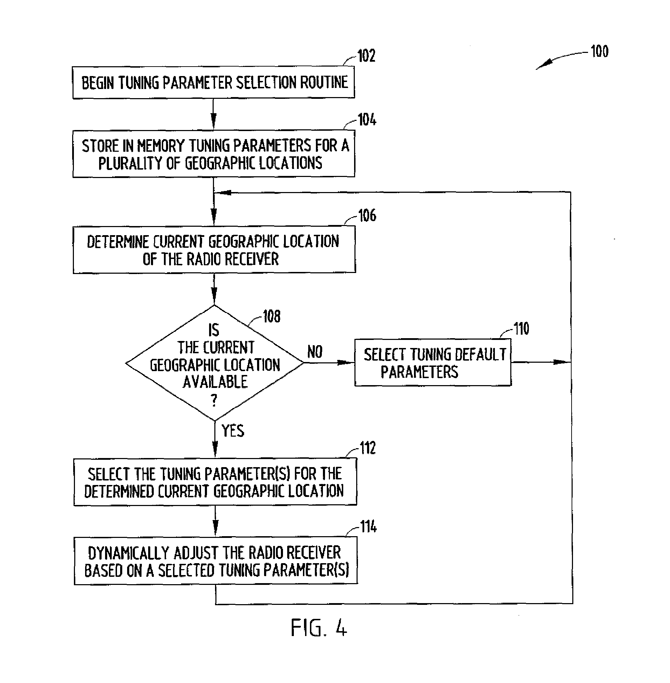

Referring to FIG. 4, the radio tuning parameter routine 100 is illustrated according to one embodiment of the present invention. The tuner parameter selection routine 100 begins at step 102 and proceeds to step 104 to store in memory tuning parameters for a plurality of geographic locations. The tuning parameters stored in memory may include the preprogrammed locations of interest tuning parameters and the dynamically programmed locations of interest tuning parameters, as well as default parameters. The tuning parameters storage step 104 may occur during configuration of the radio receiver and may be updated by a service technician or vehicle operator following the initial configuration.

In operation, the routine 100 determines the current geographic location of the radio receiver in step 106. The geographic location of the radio receiver may be obtained by known geographic location determining devices, such as the GPS receiver, according to one embodiment. According to other embodiments, the geographic location determining device may include obtaining geographic location information from a navigation system, a radio data system (RDS), telematics devices or other devices that offer geographic location information.

Next, method 100 proceeds to determine if the current geographic location is available in decision step 108. If the current geographic location is not available, routine 100 selects the tuner default parameters in step 110. As long as the current geographic location is unavailable, the tuner will be set with the default parameters initially stored in memory.

If the current geographic location is available, routine 100 proceeds to step 112 to select the tuning parameters for the determined current geographic location. The tuning parameters selected may include the programmed locations of interest tuning parameters or the dynamically programmed locations of interesting tuning parameters stored in memory. The selected tuning parameters are designated for use in certain locations to offer enhanced receiver performance. Next, in step 114, routine 100 dynamically adjusts the radio receiver, particularly the tuner, based on the selected tuning parameters such that the tuner performance is optimized to provide optimal tuning capability in various geographic locations.

It should further be appreciated that the radio receiver 10 and routine 100 could further monitor the time of day and change AM settings for changing propagation, which is the D-layer absorption transition from day to night.

Accordingly, the routine 100 and radio receiver 10 of the present invention dynamically selects tuning parameters for adjusting the tuner of the radio receiver to provide for enhanced tuner performance in various geographic locations. The receiver 10 and method 100 automatically change one or more tuning parameters as the radio receiver 10 travels amongst various locations to enhance the tuner performance, as necessary.

It will be understood by those who practice the invention and those skilled in the art, that various modifications and improvements may be made to the invention without departing from the spirit of the disclosed concept. The scope of protection afforded is to be determined by the claims and by the breadth of interpretation allowed by law.

## Claims

1. A method (100) of dynamically setting tuning parameters for a radio receiver (12), said method comprising the steps of:
storing (104) one or more tuning parameters for each of a plurality of geographic locations;
determining (106) a current geographic location of the radio receiver (12);
selecting (112) one or more tuning parameters for the determined current geographic location; and
dynamically (114) adjusting a tuner (30) based on the selected one or more tuning parameters.

2. The method as defined in claim 1, wherein the step of adjusting (114) comprises adjusting frequency bandwidth of radio receiver signals.

3. The method as defined in claim 1, wherein the step of adjusting (114) comprises adjusting gain of radio receiver signals.

4. The method as defined in claim 1, wherein the step of adjusting (114) comprises adjusting channel separation.

5. The method as defined in claim 1, wherein the step of adjusting (114) comprises adjusting roll-off of radio receiver signals.

6. The method as defined in claim 1, wherein the step of adjusting (114) comprises adjusting audio amplitude of radio receiver signals.

7. The method as defined in claim 1, wherein the step of determining a current geographic location comprises determining a geographic location with a global positioning system receiver (16).

8. The method as defined in claim 1, wherein the radio receiver (12) is a mobile receiver.

9. The method as defined in claim 1, wherein the method is performed on a radio receiver (12) in a vehicle (10).

10. The method as defined in claim 1, wherein the tuner (30) comprises a frequency modulated (FM) tuner.

11. The method as defined in claim 1 further comprising the steps of determining time of day and adjusting amplitude modulation (AM) tuner settings to change propagation based on the determined time of day.

12. A radio receiver (12) having dynamically selectable tuning parameters, said radio receiver comprising:
a first input for receiving radio frequency signals;
a second input for receiving a determined geographic location of the radio receiver;
a tuner (30) comprising tuner parameter settings;
memory (22) storing tuning parameters (24) for a plurality of geographic locations; and
a controller (20) selecting one or more tuning parameters (24) for the determined geographic location and dynamically adjusting the tuner (30) based on the selected one or more tuning parameters (24).

13. The radio receiver as defined in claim 12, wherein the controller (20) dynamically adjusts the tuner (30) by adjusting frequency bandwidth of radio receiver signals.

14. The radio receiver as defined in claim 12, wherein the controller (20) dynamically adjusts the tuner (30) by adjusting gain of radio receiver signals.

15. The radio receiver as defined in claim 12, wherein the controller (20) dynamically adjusts the tuner (30) by adjusting channel separation.

16. The radio receiver as defined in claim 12, wherein the controller (20) dynamically adjusts the tuner (30) by adjusting roll-off of radio receiver signals.

17. The radio receiver as defined in claim 12, wherein the controller (20) dynamically adjusts the tuner (30) by adjusting audio amplitude of radio receiver signals.

18. The radio receiver as defined in claim 12, wherein the second input receives a determined geographic location from a global positioning system receiver (16).

19. The radio receiver as defined in claim 12, wherein the receiver (12) is a mobile receiver.

20. The radio receiver as defined in claim 12, wherein the radio receiver (12) is located in a vehicle (10).

21. The radio receiver as defined in claim 12, wherein the tuner (30) comprises a frequency modulated tuner.

22. The radio receiver as defined in claim 12, wherein the tuner (30) comprises an amplitude modulation tuner, and wherein said controller changes amplitude modulation settings to change propagation based on time of day.
